# EUROPÄISCHE PATENTSCHRIFT

(11) **EP 1 397 737 B1**
(45) Veröffentlichungstag und Bekanntmachung des Hinweises auf die Patenterteilung: **28.09.2011**
(21) Anmeldenummer: 02737843.9
(22) Anmeldetag: 17.05.2002
(51) Int. Cl.: H05K 7/14

(54) **STECKKARTE**
PLUG-IN CARD
CARTE DE CIRCUITS IMPRIMES ENFICHABLE

(30) Priorität: 30.05.2001 DE 10126331
(43) Veröffentlichungstag der Anmeldung: 17.03.2004
(73) Patentinhaber: Fujitsu Technology Solutions Intellectual Property GmbH, 80807 München (DE)
(72) Erfinder: SCHMID, Michael, 89407 Dillingen (DE)
(74) Vertreter: Epping - Hermann - Fischer
(86) Internationale Anmeldenummer: PCT/DE2002/001784
(87) Internationale Veröffentlichungsnummer: WO 2002/097598

(56) Entgegenhaltungen:
- EP-A- 0 637 198
- FR-A- 2 433 886
- US-A- 4 991 058
- US-A- 5 136 466

## Beschreibung

Die Erfindung betrifft eine Steckkarte mit einer Leiterplatte und einem Basisbefestigungselement, das an einer Seitenkante der Leiterplatte befestigt ist, wobei die Länge des Basisbefestigungselements auf einen ersten Standard für Steckkartengrößen abgestimmt ist und wobei ein Endabschnitt des Basisbefestigungselements derart winkelförmig ausgebildet ist, dass die Leiterplatte über das Winkelstück des Endabschnitts an einem Gehäuse befestigbar ist.

Ferner betrifft die Erfindung ein Gehäuse zur Aufnahme von entsprechenden Steckkarten sowie eine Datenverarbeitungsanlage mit solchen Steckkarten.

Steckkarten dieser Art sind in vielen elektronischen Geräten vorgesehen, insbesondere in Computern. Bei den Steckkarten handelt es sich beispielsweise um Schnittstellenkarten, Modems oder Soundkarten. An einer Seite der Leiterplatte sind Kontakte vorgesehen, so dass die Leiterplatte in eine entsprechende Steckerleiste eingeschoben werden kann. Dabei entsteht ein elektrischer und mechanischer Kontakt zwischen der Leiterplatte und einer Hauptplatine, die die Steckerleiste trägt.

Das Basisbefestigungselement ist in der Regel als Metallschiene ausgebildet, wobei an einem Ende der Schiene ein Winkelstück vorgesehen ist, um das Basisbefestigungselement an einem Gehäuse, in dem sich die Hauptplatine und die Steckkarten befinden, befestigen zu können. Das Basisbefestigungselement ist an einer zweiten Kante der Steckkarte angeordnet, die senkrecht zu der die Kontakte tragenden Kante steht.

Die Befestigung des winkelförmigen Endabschnitts an dem Gehäuse ist vorzusehen, um eine ausreichende mechanische Stabilität zu erreichen, denn an dem Basisbefestigungselement sind oft Steckerbuchsen zum Anschluß von beispielsweise Kabeln vorgesehen. Beim Ein- und Ausstecken der Anschlußkabel treten mechanische Kräfte auf, die allein durch die Klemmwirkung der Steckvorrichtung für die elektrische Verbindung der Leiterplatte mit der Hauptplatine nicht aufgefangen werden können. Zudem besteht die Gefahr, dass durch die Krafteinwirkung die Leiterplatte ganz oder teilweise aus der Steckvorrichtung herausrutscht. Weiterhin kann über die Befestigungsvorrichtung sichergestellt werden, dass die Steckkarte vollständig eingesteckt ist und somit ein zuverlässiger Kontakt an allen Kontaktstellen besteht.

Die Computergehäuse sind in vielen Fällen auf die Größe der Steckkarten abgestimmt oder umgekehrt. Dabei haben sich Standards entwickelt, so dass Steckkarten in allen Standardgehäusen einsetzbar sind. Durch die fortschreitende Entwicklung der Halbleitertechnologie hat sich jedoch im Laufe der Zeit die Größe der Steckkarten bei gleicher Funktion verkleinert, so dass es nun möglich ist, auch kleinere Gehäuse zu verwenden. Folglich hat sich ein zweiter Standard für kleinere Einsteckkarten entwickelt. Problematisch ist, dass die Slotwinkel genannten Basisbefestigungselemente für Steckkarten nur für einen der Standards geeignet sind. Zur Anpassung an den größeren Standard müssen von Seiten des Herstellers die Basisbefestigungselemente länger ausgeführt sein.

Die Verwendung von Steckkarten gleicher Funktion mit unterschiedlichen Basisbefestigungselementen ist jedoch teuer, da bei der Herstellung, dem Transport und der Lagerung zusätzliche Kosten anfallen. Darüber hinaus ergeben sich Probleme bei einem eventuellen Austausch von Komponenten, weil die Ersatzkomponenten nicht nur die entsprechende Funktion, sondern auch die entsprechende Größe der Basisbefestigungselemente aufweisen müssen.

Die Druckschrift EP 0,637,198 A1 offenbart einen Adapter für Basisbefestigungselemente von Standardflachbaugruppen. Der Adapter ist ein Winkelstück, das mit dem Endabschnitt eines Basisbefestigungselements verbunden wird und den Befestigungspunkt des Basisbefestigungselements mit dem Gehäuse an einen Punkt verlagert, an dem das Lösen und Befestigen des Basisbefestigungselements von außerhalb des Gehäuses möglich ist, ohne weitere, die Montage behindernde, Komponenten im Gehäuse demontieren zu müssen. Dennoch müssen bei unterschiedlichen Standards für Steckkartengrößen entsprechende Steckkarten mit unterschiedlich langen Basisbefestigungselementen verwendet werden.

Ferner lehrt die Druckschrift FR 2,433,886 A Montagebügel für Verdrahtungsrahmen in einem Schaltschrank, wobei die Montagebügel einen Kabelkanal zwischen den elektrischen Einbaukomponenten und den tragenden Teilen des Schranks offenhalten. Steckkarten mit unterschiedlichen Größenstandards finden hier keine Anwendung.

Aufgabe der Erfindung ist es daher, eine Steckkarte anzugeben, die bei verschiedenen Gehäusegrößen mit unterschiedlichen Standards für Steckkartengrößen in Datenverarbeitungsanlagen einsetzbar ist.

Diese Aufgabe wird durch eine Steckkarte der eingangs genannten Art gelöst, die durch ein Verlängerungselement gekennzeichnet ist, das mit dem Basisbefestigungselement am winkelförmigen Endabschnitt verbunden ist und derart an das Basisbefestigungselement anschließt, dass die gesamte Länge des Basisbefestigungselements und des Verlängerungselements auf einen zweiten Standard für Steckkartengrößen abgestimmt ist, wobei ein Endabschnitt des Verlängerungselements ebenfalls winkelförmig ausgebildet und funktionsgleich zum Endabschnitt des Basisbefestigungselements ist.

Der Vorteil der erfindungsgemäßen Steckkarte mit einem Verlängerungselement besteht darin, dass eine "kleine" Steckkarte mit einem entsprechend kurzen Basisbefestigungselement durch ein Verlängerungselement so verlängerbar ist, dass die Steckkarte in einem Gehäuse einsetzbar ist, das eigentlich für "große" Steckkarten ausgelegt ist. Dabei ist insbesondere vorteilhaft, dass Steckkarten für den ersten und für den zweiten Standard gemischt in einem einheitlichen Slotfeld, also einer Anordnung mehrerer Steckplätze für Steckkarten, einsetzbar sind.

Besonders vorteilhaft ist eine U-förmige Ausgestaltung des Verlängerungselements. Die Verbindung mit dem Basisbefestigungselement kann über eine Druckfeder erfolgen, die mit dem Verlängerungselement verbunden ist und die auf den winkelförmigen Endabschnitt des ersten Basisbefestigungselements aufsteckbar ist.

In einer Weiterbildung der Erfindung ist ein Gehäuse zur Aufnahme von Steckkarten so gestaltet, dass ein I/O-Blech Aussparungen aufweist zur Aufnahme von winkelförmigen Endabschnitten an Basisbefestigungselementen der Steckkarten. Dadurch ist es möglich, erfindungsgemäße Steckkarten einzusetzen, die keine besonders schmal ausgestalteten Endabschnitte aufweisen. Das Einsetzen von Steckkarten mit schmalen winkelförmigen Endabschnitten ist trotzdem möglich, so dass ein solches Gehäuse besonders flexibel im Einsatz mit erfindungsgemäßen Steckkarten ist.

Vorteilhafterweise wird ein derartiges Gehäuse in Datenverarbeitungsanlagen mit erfindungsgemäßen Steckkarten eingesetzt.

Weitere Ausführungsformen und Vorteile sind in den Unteransprüchen angegeben.

Die Erfindung wird nachfolgend anhand von Ausführungsbeispielen näher erläutert. Es zeigt:
- Figur 1: eine erste Ausführungsform einer erfindungsgemäßen Steckkarte,
- Figur 2: ein Detail aus der Darstellung von Figur 1,
- Figur 3: eine zweite Ausführungsform einer erfindungsgemäßen Steckkarte in einer Draufsicht,
- Figur 4: eine Detail der Ausführungsform von Figur 3 in ei- ner Seitenansicht,
- Figur 5: eine dritte Ausführungsform einer erfindungsgemäßen Steckkarte und
- Figur 6: eine alternative Verbindung des Basisbefestigungs- elementes und des Verlängerungselementes in einer Detailansicht.

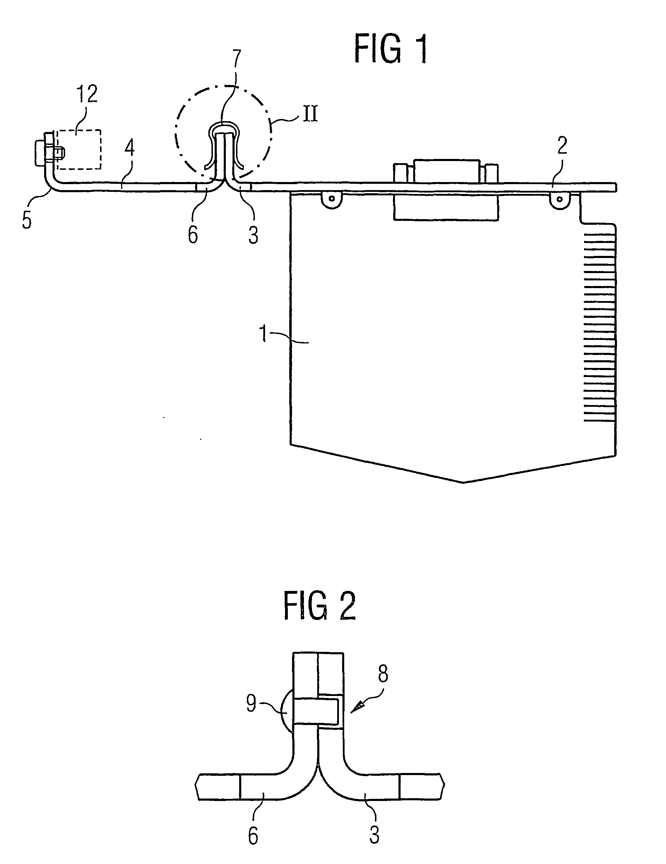

In der Figur 1 ist eine erfindungsgemäße Steckkarte mit einer Leiterplatte 1 und einem Basisbefestigungselement 2, an das sich ein Verlängerungselement 4 anschließt, dargestellt. Das Basisbefestigungselement 2 ist an einer Seitenkante der Leiterplatte 1 angeordnet und besitzt einen winkelförmigen Endabschnitt 3. Dieser ist so ausgebildet, dass die Steckkarte 1 ohne das Verlängerungselement 4 in ein "kleines" Gehäuse eingesetzt werden kann und das Basisbefestigungselement 2 an einem winkelförmigen Endabschnitt 3 mit dem Gehäuse verbindbar ist.

Das Verlängerungselement 4 besitzt ebenfalls einen winkelförmigen Endabschnitt 5, der die gleiche Funktion wie der Endabschnitt 3 des Basisbefestigungselements erfüllt, wenn das Basisbefestigungselement 2 durch das Verlängerungselement 4 verlängert und die Steckkarte 1 in ein großes Gehäuse eingesetzt ist. Der winkelförmige Endabschnitt 5 ist in der Figur 1 an einem gestrichelt gezeichneten Gehäuseteil 12 befestigt.

Zur Verbindung des Verlängerungselements 4 mit dem Basisbefestigungselement 2 ist im Ausführungsbeispiel der Figur 1 eine schematisch gezeichnete zusätzliche Klammer 7 vorgesehen. Zur Verbindung des Verlängerungselements 4 mit dem Basisbefestigungselement 2 werden die beiden Teile aneinandergelegt, so daß sich die Endabschnitte 3 und 6 berühren, und sodann die Klammer 7 über die winkelförmigen Abschnitte geschoben. Durch die Federwirkung der Klammer 7 werden die Endabschnitte aneinandergepreßt, so daß sich eine ausreichend stabile Verbindung ergibt. Die Verbindung der winkelförmigen Endabschnitte 3 und 6 ist in der Figur 2 in einer Vergrößerung dargestellt.

In der Darstellung der Figur 2 ist außerdem zur weiteren Verbesserung der Verbindung zwischen den Endabschnitten 3 und 6 ein Stift 9 vorgesehen, der mit dem Endabschnitt 6 verbunden ist und der sich in eine Ausnehmung 8 des Endabschnitts 3 erstreckt. Die Ausnehmung 8 ist ohnehin vorhanden, da dies die Bohrung ist, durch die normalerweise das Basisbefestigungselement 2 mit einer Schraube an einem Gehäuse befestigt wird.

Es muß sich aber nicht unbedingt um eine Bohrung handeln, sondern eine schlitzförmige Ausnehmung wird ebenfalls häufig angewendet. Durch den Stift 9 ergibt sich eine zusätzliche Fixierung, durch die eine zusätzliche Sicherheit gegen Verschieben der Endabschnitte 3 und 6 gegeneinander gegeben ist.

In einer vereinfachten Ausführung könnte der Stift 9 durch eine Anprägung des Endabschnitts 6 ersetzt werden. Dadurch wird ebenfalls ein Verschieben der Endabschnitte 3 und 6 gegeneinander erschwert, wobei dies in Verbindung mit einer ausreichend starken Klammer 7 ein völlig ausreichendes Ergebnis erzielt.

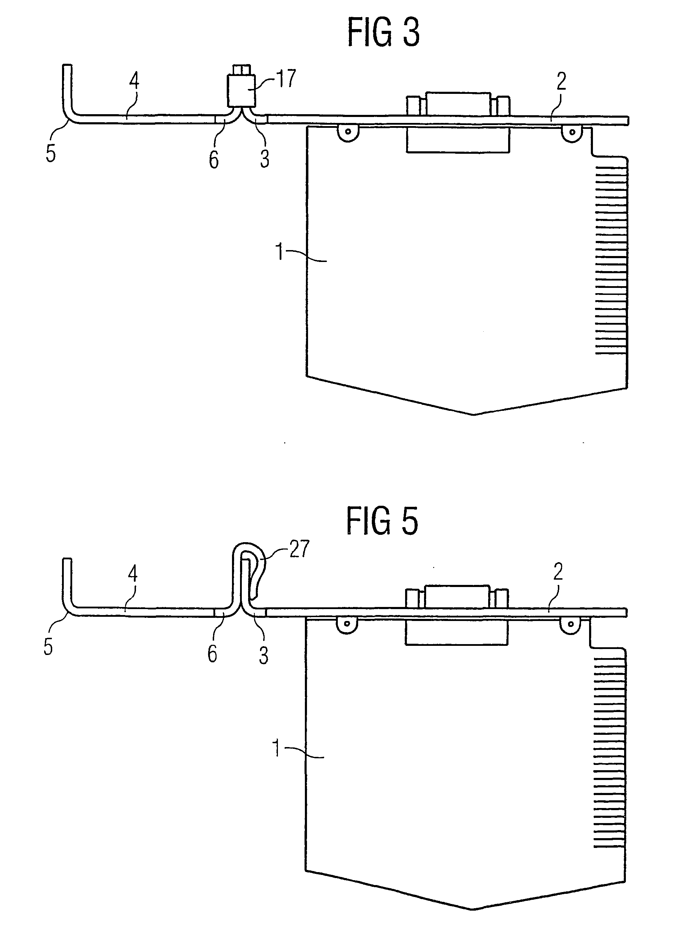

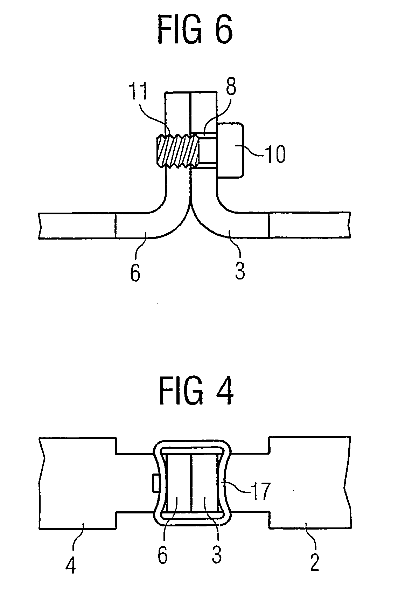

In der Figur 3 ist ein weiteres Ausführungsbeispiel einer erfindungsgemäßen Steckkarte gezeigt, wobei im dargestellten Fall das Verlängerungselement 4 und das Basisbefestigungselement 2 durch eine Druckfeder 17 miteinander verbunden sind. Die Druckfeder 17 ist fest mit dem Endabschnitt 6 des Verlängerungselements 4 verbunden. Im dargestellten Fall umgibt die Druckfeder 17 die Endabschnitte seitlich. Die Anordnung der Druckfeder an dem Endabschnitt 6 des Verlängerungselements 4 ist jedoch beliebig. Auch kann vorgesehen werden, daß die Druckfeder eine geschlossene Form aufweist, wie sie in der Figur 4 dargestellt ist.

Die Figur 5 zeigt ein drittes Ausführungsbeispiel. In diesem Fall ist nicht eine zusätzliche Druckfeder an dem Endabschnitt 6 vorgesehen, sondern der Endabschnitt 6 ist so verlängert und gebogen, daß sich ebenfalls ein federndes Element 27 ergibt. Dieses Federelement 27 ist um 180 Grad gegenüber dem winkelförmigen Endabschnitt 6 abgebogen, so daß der winkelförmige Endabschnitt 3 des Basisbefestigungselements 2 aufgenommen und festgeklemmt werden kann. Diese Ausführung ist besonders vorteilhaft, weil so keine zusätzlichen Teile verwendet werden müssen und die Herstellung des Verlängerungselements 4 besonders einfach ist.

In den bisher beschriebenen Ausführungsbeispielen wurde jeweils ein federndes Element eingesetzt, wobei das Basisbefestigungselement 2 und das Verlängerungselement 4 durch eine Klemmwirkung miteinander verbunden wurden. Die Erfindung ist jedoch nicht darauf beschränkt, sondern läßt noch andere Verbindungstechniken zwischen dem Verlängerungselement 4 und dem Basisbefestigungselement 2 zu. Eine solche Ausführung ist in Figur 6 dargestellt. In diesem Fall wird die bereits vorhandene Ausnehmung 8 in dem Endabschnitt 3 des Basisbefestigungselements 2 in Verbindung mit einer Gewindebohrung 11 in dem Endabschnitt 6 des Verlängerungselements genutzt. Durch die Ausnehmung 8 kann sich nämlich nun eine Schraube 10 erstrecken, durch die das Basisbefestigungselement 2 an seinem Endabschnitt 3 mit dem Verlängerungselement 4 an dessen Endabschnitt 6 verschraubt werden kann.

In einer weiteren Ausgestaltungsmöglichkeit, die in den Figuren aber nicht dargestellt ist, wird das Verlängerungselemente auf das Basisbefestigungselement lediglich aufgesteckt, wobei die Toleranzen so bemessen sind, daß ein federndes Element nicht mehr notwendig ist.

Damit die erfindungsgemäße Steckkarte mit vorhandenen Gehäuserückwänden, sogenannten I/O-Blechen, verwendet werden kann, muß der winkelförmige Endabschnitt so geformt sein, daß er sich durch die Ausnehmungen der I/O-Bleche erstrecken kann. Dazu kann der winkelförmige Endabschnitt zumindest im Bereich der Abbiegung schmaler sein. In einer alternativen Ausführung werden im I/O-Blech entsprechende Aussparungen vorgesehen. Dadurch ist es möglich, eine erfindungsgemäße Steckkarte einzusetzen, die keine besonders schmal ausgestalteten Endabschnitte aufweist. Das Einsetzen einer Steckkarte mit schmalem winkelförmigem Endabschnitt ist trotzdem möglich, so daß ein solches Gehäuse besonders flexibel im Einsatz mit erfindungsgemäßen Steckkarten ist.

### Bezugszeichenliste

- 1: Steckkarte
- 2: Basisbefestigungselement
- 3: Endabschnitt des Basisbefestigungselements
- 4: Verlängerungselement
- 5: erster Endabschnitt des Verlängerungselements
- 6: zweiter Endabschnitt des Verlängerungselements
- 7: Klammer
- 8: Ausnehmung
- 9: Stift
- 10: Schraube
- 11: Gewindebohrung
- 12: Gehäuseteil
- 17: Druckfeder
- 27: federndes Element

## Patentansprüche

1. Steckkarte mit
- einer Leiterplatte (1) und
- einem Basisbefestigungselement (2), das an einer Seitenkante der Leiterplatte (1) befestigt ist, wobei die Länge des Basisbefestigungselements (2) auf einen ersten Standard für Steckkartengrößen abgestimmt ist und wobei ein Endabschnitt (3) des Basisbefestigungselements (2) derart winkelförmig ausgebildet ist, dass die Leiterplatte über das Winkelstück des Endabschnitts (3) an einem Gehäuse befestigbar ist,
**gekennzeichnet durch**
ein Verlängerungselement (4), das mit dem Basisbefestigungselement (2) am winkelförmigen Endabschnitt (3) verbunden ist und derart an das Basisbefestigungselement (2) anschließt, dass die gesamte Länge des Basisbefestigungselements (2) und des Verlängerungselements (4) auf einen zweiten Standard für Steckkartengrößen abgestimmt ist, wobei ein Endabschnitt (5) des Verlängerungselements (4) ebenfalls winkelförmig ausgebildet und funktionsgleich zum Endabschnitt (3) des Basisbefestigungselements (2) ist.

2. Steckkarte nach Anspruch 1,
**dadurch gekennzeichnet, dass**
auch ein zweiter Endabschnitt (6) des Verlängerungselements (4) zur Verbindung mit dem Basisbefestigungselement (2) winkelförmig ausgebildet ist, so dass das Verlängerungselement (4) eine U-förmige Gestalt besitzt.

3. Steckkarte nach Anspruch 2,
**dadurch gekennzeichnet, dass**
an dem zweiten Endabschnitt (6) des Verlängerungselements (4) ein federndes Element (7, 17, 27) vorgesehen ist zur Befestigung des Verlängerungselements (4) an dem Basisbefestigungselement (2) durch Aufnahme des winkelförmigen Endabschnitts (3) des Basisbefestigungselements (2) zwischen dem federnden Element (7, 17, 27) und dem winkelförmigen Endabschnitt (6) des Verlängerungselements (4).

4. Steckkarte nach Anspruch 3,
**dadurch gekennzeichnet, dass**
ein federndes Element (27) durch eine Verlängerung des winkelförmigen Endabschnitts (6) des Verlängerungselements (4) gebildet ist.

5. Steckkarte nach Anspruch 3,
**dadurch gekennzeichnet, dass**
als federndes Element eine Druckfeder (17) vorgesehen ist.

6. Steckkarte nach Anspruch 2,
**dadurch gekennzeichnet, dass**
eine zusätzliche Klammer (7) vorgesehen ist zur Verbindung der winkelförmigen Endabschnitte (3, 6) des Basisbefestigungselements (2) und des Verlängerungselements (4)

7. Gehäuse mit Steckkarten nach einem der Ansprüche 1 bis 6, wobei an einer Seite des Gehäuses ein I/O-Blech mit Zugang zu Anschlüssen der Steckkarten vorgesehen ist und wobei das I/O-Blech Aussparungen aufweist zur Aufnahme von winkelförmigen Endabschnitten (3) an Basisbefestigungselementen (2) der Steckkarten.

8. Datenverarbeitungsanlage mit einer Vielzahl von Steckplätzen, in die Steckkarten aufgenommen sind,
**dadurch gekennzeichnet, dass**
zumindest ein Teil der Steckkarten nach einem der Ansprüche 1 bis 6 ausgebildet ist.

9. Datenverarbeitungsanlage nach Anspruch 8,
**gekennzeichnet durch**
ein Gehäuse nach Anspruch 7.

## Claims

1. Plug-in card with
- a printed circuit board (1) and
- a base attachment element (2), which is attached to a side edge of the printed circuit board (1), the length of the base attachment element (2) being made to conform to a first standard for plug-in card sizes and an end portion (3) of the base attachment element (2) being formed in an angular manner in such a way, that the printed circuit board can be attached to a housing by means of the angled piece of the end portion (3), **characterized by**
- an extension element (4), which is connected to the base attachment element (2) at the angular end portion (3) and adjoins the base attachment element (2) in such a way that the overall length of the base attachment element (2) and the extension element (4) is made to match a second standard for plug-in card sizes, an end portion (5) of the extension element (4) likewise being formed in an angular manner and being functionally the same as the end portion (3) of the base attachment element (2).

2. Plug-in card according to Claim 1, **characterized in that** a second end portion (6) of the extension element (4) is also formed in an angular manner for connection to the base attachment element (2), so that the extension element (4) has a U-shaped form.

3. Plug-in card according to Claim 2, **characterized in that**, on the second end portion (6) of the extension element (4) a resilient element (7, 17, 27) is provided for attaching the extension element (4) to the base attachment element (2) by receiving the angular end portion (3) of the base attachment element (2) between the resilient element (7, 17, 27) and the angular end portion (6) of the extension element (4).

4. Plug-in card according to Claim 3, **characterized in that** a resilient element (27) is formed by an extension of the angular end portion (6) of the extension element (4).

5. Plug-in card according to Claim 3, **characterized in that** a compression spring (17) is provided as the resilient element.

6. Plug-in card according to Claim 2, **characterized in that** an additional clip (7) is provided for the connection of the angular end portions (3, 6) of the base attachment element (2) and the extension element (4).

7. Housing having plug-in cards according to one of Claims 1 to 6, an I/O plate being provided on one side of the housing with access to the terminals of the plug-in cards, and the I/O plate having openings for receiving the angular end portions (3) on base attachment elements (2) of the plug-in cards.

8. Data processing system with a multiplicity of slots in which plug-in cards are received, **characterized in that** at least some of the plug-in cards are formed according to one of Claims 1 to 6.

9. Data processing system according to Claim 8, **characterized by** a housing according to Claim 7.

## Revendications

1. Carte enfichable avec
- une plaque à circuit imprimé (1) et
- un élément de fixation de base (2) qui est fixé à une arête latérale de la plaque à circuit imprimé (1), la longueur de l'élément de fixation de base (2) concordant avec une première norme relative aux dimensions des cartes enfichables et une portion d'extrémité (3) de l'élément de fixation de base (2) étant formée de manière angulaire de sorte que la plaque à circuit imprimé puisse être fixée à un boîtier par l'intermédiaire du raccord angulaire de la portion d'extrémité (3),
**caractérisée par**
un élément de rallonge (4) qui est relié à l'élément de fixation de base (2) au niveau de la portion d'extrémité angulaire (3) et se raccorde à l'élément de fixation de base (2) de sorte que la longueur totale de l'élément de fixation de base (2) et de l'élément de rallonge (4) concorde avec une seconde norme relative aux dimensions des cartes enfichables, une portion d'extrémité (5) de l'élément de rallonge (4) étant également formée de manière angulaire et ayant la même fonction que la portion d'extrémité (3) de l'élément de fixation de base (2).

2. Carte enfichable selon la revendication 1, **caractérisée en ce qu'**également une seconde portion d'extrémité (6) de l'élément de rallonge (4) est formée de manière angulaire en vue d'une liaison avec l'élément de fixation de base (2), de sorte que l'élément de rallonge (4) possède une forme en U.

3. Carte enfichable selon la revendication 2, **caractérisée en ce qu'**au niveau de la seconde portion d'extrémité (6) de l'élément de rallonge (4) est prévu un élément élastique (7, 17, 27) pour fixer l'élément de rallonge (4) à l'élément de fixation de base (2) par réception de la portion d'extrémité angulaire (3) de l'élément de fixation de base (2) entre l'élément élastique (7, 17, 27) et la portion d'extrémité angulaire (6) de l'élément de rallonge (4).

4. Carte enfichable selon la revendication 3, **caractérisée en ce qu'**un élément élastique (27) est formé par un prolongement de la portion d'extrémité angulaire (6) de l'élément de rallonge (4).

5. Carte enfichable selon la revendication 3, **caractérisée en ce qu'**un ressort de compression (17) est prévu comme élément élastique.

6. Carte enfichable selon la revendication 2, **caractérisée en ce qu'**un crampon supplémentaire (7) est prévu pour relier les portions d'extrémité angulaires (3, 6) de l'élément de fixation de base (2) et de l'élément de rallonge (4).

7. Boîtier avec cartes enfichables selon l'une des revendications 1 à 6, dans lequel est prévu, sur un côté du boîtier, une plaque E/S avec accès à des connexions des cartes enfichables et dans lequel la plaque E/S présente des ouvertures pour recevoir des portions d'extrémité angulaires (3) au niveau d'éléments de fixation de base (2) des cartes enfichables.

8. Installation de traitement de données avec une pluralité d'emplacements d'enfichage dans lesquels des cartes enfichables sont reçues, **caractérisée en ce qu'**au moins une partie des cartes enfichables est formée selon l'une des revendications 1 à 6.

9. Installation de traitement de données selon la revendication 8, **caractérisée par** un boîtier selon la revendication 7.
